# FASCICULE DE BREVET EUROPEEN

(11) **EP 3 504 556 B1**
(45) Date de publication et mention de la délivrance du brevet: **28.09.2022**
(21) Numéro de dépôt: 17765231.0
(22) Date de dépôt: 10.08.2017
(51) Int. Cl.: G01R 31/34, F02K 1/76

(54) **PROCEDE DE TEST INTEGRE DU FONCTIONNEMENT ELECTRIQUE DE L'INVERSION DE POUSSEE D'UN TURBOREACTEUR D'UN AERONEF, ET SYSTEME ASSOCIE.**
INTEGRIERTES PRÜFVERFAHREN ZUM PRÜFEN DES ELEKTRISCHEN BETRIEBS DER SCHUBUMKEHR EINES TRIEBWERKS EINES FLUGZEUGS UND ENTSPRECHENDES SYSTEM
INTEGRATED TEST METHOD FOR TESTING THE ELECTRICAL OPERATION OF THE THRUST REVERSAL OF A JET ENGINE OF AN AIRCRAFT, AND ASSOCIATED SYSTEM.

(30) Priorité: 24.08.2016 FR 1657895
(43) Date de publication de la demande: 03.07.2019
(73) Titulaire: Safran Aircraft Engines, 75015 Paris (FR)
(72) Inventeur: SEKA, Florian Boni, 77550 Moissy-Cramayel Cedex (FR)
(74) Mandataire: Cabinet Beau de Loménie
(86) Numéro de dépôt international: PCT/FR2017/052216
(87) Numéro de publication internationale: WO 2018/037182

(56) Documents cités:
- FR-A1- 2 919 772
- JP-A- 2004 112 939
- US-A1- 2012 280 641
- US-A1- 2015 222 214

## Description

### Arrière-plan de l'invention

L'invention concerne un procédé de test intégré du fonctionnement du système électrique de commande de l'inversion de poussée d'un turboréacteur d'un aéronef.

Dans un aéronef, l'architecture des inverseurs de poussée électriques repose généralement sur un convertisseur électrique d'entraînement à vitesse variable, ou contrôleur de puissance, couplé à un moteur électrique entraînant un système d'actionnement de l'inversion de poussée.

Le convertisseur électrique transforme la puissance électrique fournie par l'avion pour bâtir un couple mécanique en sortie d'arbre moteur et ainsi alimenter en puissance mécanique toute la chaîne cinématique responsable de l'inversion de poussée.

Le fonctionnement de ce convertisseur électrique ne peut pas être testé en vol. Plus précisément, il n'est pas possible actuellement de tester le fonctionnement d'un tel convertisseur électrique préalablement à l'utilisation de l'inversion de poussée. La raison principale et logique est qu'une activation en vol des inverseurs de poussée est proscrite car elle générerait une contre poussée et une perte de vitesse à un instant non recommandé.

Ainsi, actuellement, une éventuelle indisponibilité du convertisseur électrique du système d'actionnement ne peut être détectée en vol qu'au moment où la fonction inverseur est requise. Le pilote ne se rend donc compte du disfonctionnement qu'au moment de l'activation de l'inversion de poussée en phase d'atterrissage. Les documents

US2015/222214 A1, US2012/280641 A1 et FR2919772 A1 divulguent un état de la technique pertinent.

### Objet et résumé de l'invention

L'invention vise à fournir un procédé de test intégré permettant de commander, au cours du vol d'un aéronef, la réalisation d'un test du fonctionnement du convertisseur électrique commandant le moteur électrique actionnant une inversion de poussée d'un turboréacteur, et ainsi de diminuer les dormances appliquées à ces systèmes au titre de la sûreté de fonctionnement.

Un objet de l'invention propose un procédé de test intégré du fonctionnement d'un convertisseur électrique de puissance commandant un moteur électrique triphasé configuré pour actionner une inversion de poussée d'un turboréacteur d'un aéronef, le convertisseur électrique de puissance commandant le moteur électrique à partir d'une commande à orientation de champs générant des courants définis à partir d'une composante directe de courant et d'une composante quadratique de courant, le procédé comprenant les étapes suivantes :
a) une réception d'une commande d'initiation du test intégré,
b) une commande du convertisseur électrique de puissance à partir d'une consigne de courant définie à partir d'une composante directe non nulle et d'une composante quadratique nulle,
c) une mesure des courants délivrés sur chacune des trois phases en sortie du convertisseur électrique de puissance,
d) une détermination des composantes directe et quadratique du courant triphasé mesuré à l'étape précédente,
e) une comparaison des composantes directe et quadratique du courant mesuré avec les composantes directe et quadratique de la consigne de courant, et
f) l'émission d'une notification à l'équipage de l'aéronef du disfonctionnement ou de fonctionnement de l'inversion de poussée en fonction du résultat de ladite comparaison.

Ce procédé peut être mis en œuvre sans modifier les boucles existantes de régulation du convertisseur électrique de puissance commandant le moteur électrique triphasé, seules les consignes en entrée de ces boucles étant modifiées.

Le procédé permet en outre d'informer l'équipage qu'un inverseur de poussée est indisponible avant que la phase d'atterrissage ne soit amorcée.

Dans une machine électrique, notamment une machine synchrone triphasée à aimants permanents, les courants dans les trois phases du stator sont sinusoïdaux et déphasés chacun de 2π/3 rad. Ces courants créent un champ magnétique tournant dans la machine électrique. Le rotor est composé d'aimants permanents, par exemple entre 1 et 5 paires de pôles. Comme une boussole, le rotor s'aligne naturellement sur le champ magnétique tournant créé par le stator. Ce sont les amplitudes des courants du stator et la puissance des aimants du rotor qui crée le couple nécessaire à la rotation de la machine. Pour commander ces courants, il faut donc appliquer à chaque phase du stator des tensions sinusoïdales déphasées de 2π/3 rad chacune également.

Généralement, il est plus simple d'appliquer une régulation sur des constantes que sur des signaux sinusoïdaux. La transformée de Park, qui est une transformée des systèmes triphasées, est généralement utilisée pour projeter un système triphasé sur un espace bidimensionnel, dit de Park, afin de traiter la régulation des courants dans un système monophasé équivalent. Il est ainsi possible de transposer les trois courants et les trois tensions sinusoïdales du stator relatives aux trois phases d'un système triphasé dans un espace où les trois signaux sinusoïdaux de courant ou de tension s'expriment sous la forme de deux signaux constants de courant ou de tension, l'un sur l'axe direct Xd et l'autre sur l'axe en quadrature Xq. Pour cela, le repère de Park s'appuie sur un repère lié au champ tournant, soit dans le cas de la machine synchrone à un repère lié au rotor.

En travaillant avec des courants et des tensions exprimées dans un plan lié à une transformée de systèmes triphasés tel que l'espace de Park, il est ainsi possible d'agir sur des courants ou des tensions constantes plutôt que des signaux sinusoïdaux pour réguler la machine triphasée à commander.

La transformée de Park permet ainsi de commander une machine électrique tournante triphasée à partir d'un système à deux composantes, directe et quadratique.

Une commande à orientation de champs d'un convertisseur électrique s'appuie sur une telle commande à deux composantes. La commande par orientation de champs a l'avantage de résumer le contrôle d'une machine électrique triphasée, et notamment une machine synchrone à aimants permanents à la régulation de deux grandeurs de courant, une composante directe et une composante quadratique, dans le repère tournant électrique de la machine.

La composante quadratique du courant, notée Iq, est proportionnelle au couple développé par le moteur. Il s'agit donc de la grandeur d'ajustement utilisée pour réguler le couple, voire la vitesse et la position du système mécanique, lorsque l'inversion de poussée est actionnée. La composante directe du courant, notée Id, est généralement maintenue à une valeur nulle.

Le procédé de test est intégré en ce qu'il peut être initié par le système avion pendant le vol ou sur requête de l'équipage pendant le vol ou au cours de l'approche.

Ce test intégré permet d'alimenter le convertisseur électrique en énergie électrique et d'activer un mode particulier du convertisseur consistant, en régulation de courant, à utiliser la composante directe du courant en consigne non nulle et la composante quadratique du courant en consigne nulle afin de produire des courants de circulation dans l'étage d'ondulation du convertisseur et des courants de circulation dans le moteur électrique, sans que le moteur ne développe aucun couple mécanique.

De la sorte, les éléments de rétention ne sont pas sollicités mécaniquement et aucun déploiement en vol n'est initié. Il n'y a donc aucun matage des verrous, aucune sollicitation des systèmes de freinage.

D'autre part, la mesure des courants conformes à la consigne permet de confirmer non seulement la disponibilité de l'alimentation avion, mais aussi la disponibilité de l'intégralité du système de conversion électrique et de ses composants, ainsi que le fonctionnement de la connexion convertisseur/moteur (harnais), et l'état nominal des bobinages moteurs.

Selon un premier aspect du procédé de test intégré, une notification d'alerte est émise à l'étape f) si les composantes mesurées diffèrent des composantes de la consigne de courant avec une variance supérieure à un seuil prédéterminé variable en fonction des spécificités de l'application.

En d'autres termes, si la variante de la comparaison réalisée à l'étape e) est supérieure à un seuil prédéterminé, une notification d'alerte est émise à l'étape f), le seuil prédéterminé variant en fonction des spécificités de l'application.

Selon un deuxième aspect du procédé de test intégré, aucune notification n'est émise si les composantes mesurées correspondent aux composantes de la consigne de courant avec une variance inférieure à un seuil prédéterminé variable en fonction des spécificités de l'application.

Dans une variante, une notification de réussite du test et de bon fonctionnement de l'inversion de poussée est émise si les composantes mesurées correspondent aux composantes de la consigne de courant avec une variance inférieure à un seuil prédéterminé variable en fonction des spécificités de l'application.

Selon un troisième aspect du procédé, le procédé peut comprendre une réalisation des étapes b) à e) pour chaque turboréacteur de l'aéronef, les étapes b) à e) étant réalisées simultanément pour tous les turboréacteurs ou successivement pour chaque turboréacteur.

Le test intégré peut ainsi être réalisé sur tous les inverseurs de poussée de l'avion de manière concomitante ou séquentielle. En cas d'échec de ce test intégré, le pilote est informé de la perte de la fonction inverseur du (des) moteur(s) en question.

Un autre objet de l'invention propose un système de commande d'une phase de test d'un convertisseur électrique de puissance destiné à être intégré à un convertisseur électrique de puissance destiné à commander un moteur électrique triphasé configuré pour actionner une inversion de poussée d'un turboréacteur d'un aéronef, le convertisseur électrique de puissance étant destiné à être alimenté par un réseau d'alimentation électrique de l'aéronef et à être commandé à partir d'une commande à orientation de champs utilisant une consigne de courant définie à partir d'une composante directe de courant et d'une composante quadratique de courant.

Selon une caractéristique générale de l'invention, le système comprend des moyens de réception d'une consigne d'initiation du test intégré, des moyens de commande du convertisseur électrique de puissance à partir d'une consigne de courant définie à partir d'une composante directe non nulle et d'une composante quadratique nulle, des moyens de mesure des courants délivrés sur chacune des trois phases en sortie du convertisseur électrique de puissance, des moyens de détermination des composantes directe et quadratique du courant triphasé mesuré à l'étape précédente, des moyens de comparaison des composantes directe et quadratique du courant mesuré aux composantes directe et quadratique de la consigne de courant, et des moyens d'émission d'une notification à l'équipage de l'aéronef du disfonctionnement ou du fonctionnement de l'inversion de poussée configurés pour émettre une notification en fonction du résultat de ladite comparaison.

Les moyens du système peuvent être des modules électroniques ou des moyens implémentés par logiciel.

Encore un autre objet de l'invention propose un convertisseur électrique de puissance destiné à être alimenté par un réseau d'alimentation électrique d'un aéronef et à être couplé à un moteur électrique triphasé configuré pour actionner une inversion de poussée d'un turboréacteur de l'aéronef, le convertisseur étant configuré pour être commandé à partir d'une commande à orientation de champs utilisant une consigne de courant définie à partir d'une composante directe de courant et d'une composante quadratique de courant.

Selon une caractéristique générale de l'objet, le convertisseur électrique de puissance comprend un système de commande d'une phase de test du fonctionnement dudit convertisseur électrique de puissance tel que défini ci-dessus.

Un autre objet de l'invention propose un turboréacteur comprenant un convertisseur électrique de puissance tel que défini ci-dessus électriquement couplé à un moteur électrique synchrone à aimants permanents configuré pour actionner une inversion de poussée d'une turboréacteur d'un aéronef.

Un autre objet de l'invention propose un aéronef comprenant au moins un turboréacteur tel que défini ci-dessus.

### Brève description des dessins.

L'invention sera mieux comprise à la lecture faite ci-après, à titre indicatif mais non limitatif, en référence aux dessins annexés sur lesquels :
- la figure 1 est une représentation schématique d'un système d'inversion de poussée d'un turboréacteur d'un aéronef,
- la figure 2 présente un schéma synoptique d'un procédé de test intégré du fonctionnement d'un convertisseur électrique de puissance du système d'inversion de poussée de la figure 1.

### Description détaillée de modes de réalisation

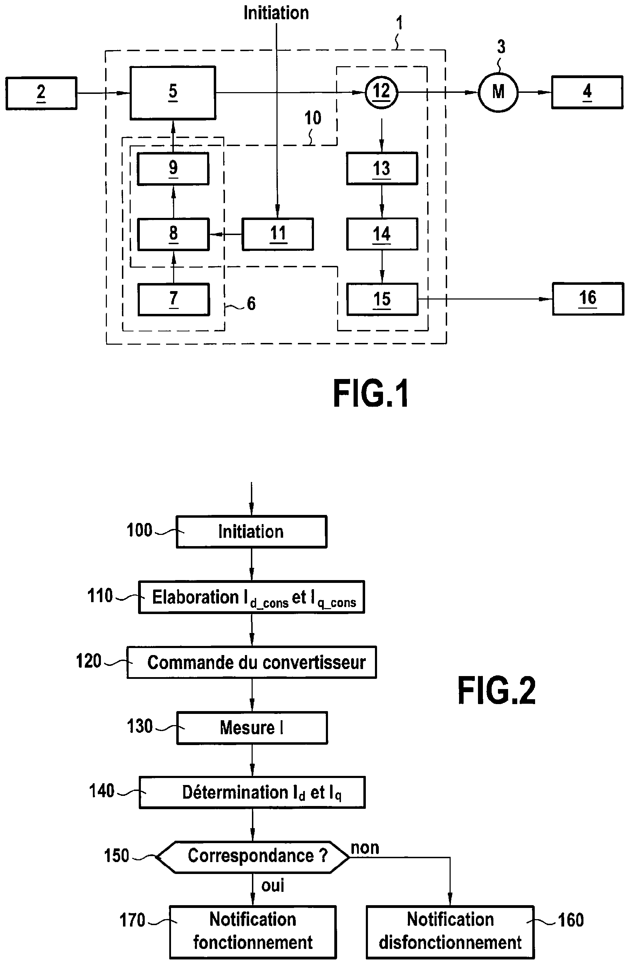

Sur la figure 1 est représenté schématiquement un système d'inversion de poussée d'un turboréacteur d'un aéronef.

Le système d'inversion de poussée comprend un convertisseur électrique de puissance 1 alimenté par un réseau d'alimentation électrique 2 embarqué à bord de l'aéronef. Le convertisseur électrique de puissance 1 est électriquement raccordé en sortie à un moteur électrique 3 qui est mécaniquement couplé en sortie à un dispositif 4 d'actionnement mécanique de l'inversion de poussée.

Dans ce mode de réalisation, le moteur électrique 3 est un moteur synchrone à aimants permanents.

Le convertisseur électrique de puissance 1 comprend un bloc de puissance 5 comportant des interrupteurs commandés permettant de moduler le courant délivré en entrée au bloc de puissance 5 par le réseau d'alimentation électrique 2 et de délivrer un courant triphasé au moteur électrique 3. Le bloc de puissance 5 est configuré pour être commandé à partir d'une commande à orientation de champs utilisant une consigne de courant définie à partir d'une composante directe de courant Id et d'une composante quadratique de courant Iq. Le convertisseur électrique de puissance 1 comprend en outre des moyens de commande 6 du bloc de puissance 5 pour l'inversion de poussée.

Les moyens de commande 6 comprennent un module 7 d'élaboration des boucles de régulation de vitesse et de position, dont le rôle est d'assurer un profil de déploiement et d'escamotage de l'inverseur compatible des charges et des cinématiques souhaitées, le module 7 étant couplé en sortie à un module 8 de commande des boucles de régulation des composante directe et quadratique Id_cons et Iq_cons des consignes de courant, le module 8 étant couplé en sortie à un module 9 de génération des impulsions de commande raccordé au bloc de puissance 5 et configuré pour commander les interrupteurs commandés du bloc de puissance 5.

Le convertisseur électrique de puissance 1 comprend en outre un système de commande 10 d'une phase de test du convertisseur électrique de puissance 1.

Le système de commande 10 comprend des moyens de réception 11 d'une consigne d'initiation du test intégré qui peut être généré par l'activation d'un bouton d'actionnement de test par un membre de l'équipage de l'aéronef, et des moyens de commande du convertisseur électrique de puissance en mode test.

Dans ce mode de réalisation, les moyens de commande du convertisseur électrique de puissance en mode test comprennent le module 8 de commande des boucles de régulation des composante directe et quadratique I_{d_cons} et I_{q_cons} des consignes de courant et le module 9 de génération des impulsions de commande.

A la réception d'un signal émis par les moyens de réception 11, le module 8 élabore une consigne de courant à partir d'une composante directe I_{d_cons} non nulle et d'une composante quadratique I_{q_cons} nulle, et le module 9 délivre les commandes au bloc de puissance 5.

Le système de commande 10 comprend en outre des moyens 12 de mesure des courants délivrés sur chacune des trois phases en sortie du convertisseur électrique de puissance 1, et plus précisément montés en sortie du bloc de puissance 5. Le système de commande 10 comprend en outre des moyens 13 de détermination des composantes directe et quadratique du courant triphasé mesuré par les moyens de mesure 12, et des moyens 14 de comparaison des composantes directe et quadratique du courant mesuré aux composantes directe et quadratique de la consigne de courant.

Le système de commande 10 comprend enfin des moyens 15 d'émission d'une notification à l'équipage de l'aéronef du disfonctionnement de l'inversion de poussée. Les moyens d'émission 15 sont configurés pour émettre une notification en fonction du résultat de ladite comparaison, la notification étant affichée sur un afficheur 16 visible par les membres de l'équipage de l'aéronef.

La phase de test est mise en œuvre selon le procédé dont le schéma synoptique est illustré sur la figure 2.

Le procédé comprend tout d'abord une première étape 100 de réception d'une commande d'initiation du test intégré. La commande est générée ici par l'activation d'un bouton d'actionnement de test par un membre de l'équipage de l'aéronef. Dans une variante, la commande peut être initiée de manière automatique

Dans une étape suivante 110, on élabore une consigne de courant définie à partir d'une composante directe non nulle et d'une composante quadratique nulle, puis, dans une étape suivante 120, on commande le bloc de puissance 5 du convertisseur électrique de puissance 1 à partir de la consigne de courant élaborée à l'étape précédente 110.

On mesure ensuite dans une étape suivante 130 les courants délivrés sur chacune des trois phases en sortie du convertisseur électrique de puissance 5.

Dans une étape suivante 140, on détermine les composantes directe et quadratique du courant triphasé mesuré à l'étape précédente 130, puis on compare, dans une étape 150, les composantes directe et quadratique du courant mesuré aux composantes directe et quadratique de la consigne de courant.

Si les composantes mesurées diffèrent des composantes de la consigne de courant avec une variance supérieure à un seuil de décision prédéterminé, par exemple 10%, une notification d'alerte de disfonctionnement de l'inversion de poussée est émise dans une étape 160 vers un afficheur 16 disposé dans l'aéronef.

En revanche, si les composantes mesurées correspondent aux composantes de la consigne de courant avec une variance inférieure au seuil de décision prédéterminé, dans une étape 170, une notification relative au bon fonctionnement de l'inversion de poussée est émise vers l'afficheur 16.

Dans une variante, le bon fonctionnement pourrait être indiquée par l'absence d'émission de notification, seule une notification de disfonctionnement étant émise si les composantes mesurées diffèrent des composantes de la consigne de courant avec une variance supérieure à un seuil de décision prédéterminé.

Les étapes 110 à 170 peuvent être réalisées simultanément ou successivement pour chaque turboréacteur de l'aéronef.

L'invention fournit ainsi un procédé de test intégré permettant de commander, au cours du vol d'un aéronef, la réalisation d'un test du fonctionnement du convertisseur électrique commandant le moteur électrique actionnant l'inversion de poussée d'un turboréacteur, et ainsi de diminuer les dormances appliquées à ces systèmes au titre de la sûreté de fonctionnement.

## Revendications

1. Procédé de test intégré du fonctionnement d'un convertisseur électrique de puissance (1) commandant un moteur électrique triphasé (3) configuré pour actionner une inversion de poussée (4) d'un turboréacteur d'un aéronef, le convertisseur électrique de puissance (1) étant alimenté par un réseau d'alimentation électrique (2) de l'aéronef et commandé à partir d'une commande à orientation de champs utilisant une consigne de courant définie à partir d'une composante directe de courant et d'une composante quadratique de courant, le procédé comprenant les étapes suivantes :
a) une réception (100) d'une commande d'initiation du test intégré,
b) une commande (120) du convertisseur électrique de puissance (1) à partir d'une consigne de courant définie à partir d'une composante directe (I_{d_cons}) non nulle et d'une composante quadratique (I_{q_cons}) nulle,
c) une mesure (130) des courants délivrés sur chacune des trois phases en sortie du convertisseur électrique de puissance (1),
d) une détermination (140) des composantes directe et quadratique (I_{d}, I_{q}) du courant triphasé mesuré à l'étape précédente,
e) une comparaison (150) des composantes directe et quadratique (I_{d}, I_{q}) du courant mesuré avec les composantes directe et quadratique (I_{d_cons}, I_{q_cons}) de la consigne de courant, et
f) une émission (160) d'une notification à l'équipage de l'aéronef du disfonctionnement ou de fonctionnement de l'inversion de poussée en fonction du résultat de ladite comparaison.

2. Procédé selon la revendication 1, dans lequel une notification d'alerte est émise à l'étape f) (160) si les composantes mesurées (I_{d}, I_{q}) diffèrent des composantes (I_{d_cons}, I_{q_cons}) de la consigne de courant avec une variance supérieure à un seuil de décision prédéterminé.

3. Procédé selon l'une des revendications 1 ou 2, dans lequel aucune notification (170) n'est émise si les composantes mesurées (I_{d}, I_{q}) correspondent aux composantes (I_{d_cons}, I_{q_cons}) de la consigne de courant avec une variance inférieure à un seuil de décision prédéterminé .

4. Procédé selon l'une des revendications 1 ou 2, dans lequel une notification de réussite du test et de bon fonctionnement de l'inversion de poussée est émise si les composantes mesurées (I_{d}, I_{q}) correspondent aux composantes d(I_{d_cons}, I_{q_cons}) de la consigne de courant avec une variance inférieure à un seuil de décision prédéterminé .

5. Procédé selon l'une des revendications 1 à 4, comprenant une réalisation des étapes b) à f) pour chaque turboréacteur de l'aéronef, les étapes b) à f) étant réalisées simultanément pour tous les turboréacteurs ou successivement pour chaque turboréacteur.

6. Système de commande (10) d'une phase de test d'un convertisseur électrique de puissance (1), le système de commande (10) étant destiné à être intégré au convertisseur électrique de puissance (1) testé, ledit convertisseur (1) étant destiné à commander un moteur électrique triphasé (3) configuré pour actionner une inversion de poussée (4) d'un turboréacteur d'un aéronef, le convertisseur électrique de puissance (1) étant destiné à être alimenté par un réseau d'alimentation électrique (2) de l'aéronef et à être commandé à partir d'une commande à orientation de champs utilisant une consigne de courant définie à partir d'une composante directe de courant et d'une composante quadratique de courant,
**caractérisé en ce qu'**il comprend des moyens (11) de réception d'une consigne d'initiation du test intégré, des moyens (8 et 9) de commande du convertisseur électrique de puissance (1) à partir d'une consigne de courant définie à partir d'une composante directe (I_{d_cons}) non nulle et d'une composante quadratique (I_{q_cons}) nulle, des moyens (12) de mesure des courants délivrés sur chacune des trois phases en sortie du convertisseur électrique de puissance (1), des moyens (13) de détermination des composantes directe et quadratique du courant triphasé mesuré à l'étape précédente, des moyens (14) de comparaison des composantes directe et quadratique du courant mesuré aux composantes directe et quadratique de la consigne de courant, et des moyens (15) d'émission d'une notification à l'équipage de l'aéronef du disfonctionnement ou du fonctionnement de l'inversion de poussée configurés pour émettre une notification en fonction du résultat de ladite comparaison.

7. Convertisseur électrique de puissance (1) destiné à être alimenté par un réseau d'alimentation électrique (2) d'un aéronef et à être couplé à un moteur électrique triphasé (3) configuré pour actionner une inversion de poussée (4) d'un turboréacteur de l'aéronef, ledit convertisseur (1) étant configuré pour être commandé à partir d'une commande à orientation de champs utilisant une consigne de courant définie à partir d'une composante directe de courant et d'une composante quadratique de courant,
**caractérisé en ce que** le convertisseur électrique de puissance (1) comprend un système de commande (10) d'une phase de test du fonctionnement dudit convertisseur électrique de puissance (1) selon la revendication 6.

8. Turboréacteur comprenant un convertisseur électrique de puissance (1) selon la revendication précédente électriquement couplé à un moteur électrique synchrone à aimants permanents (3) configuré pour actionner une inversion de poussée (4) d'un turboréacteur d'un aéronef.

9. Aéronef comprenant au moins un turboréacteur selon la revendication précédente.

## Patentansprüche

1. Integriertes Verfahren zum Prüfen der Funktion eines elektrischen Leistungswandlers (1), der einen Drehstrommotor (3) steuert, der dazu ausgestaltet ist, eine Schubumkehr (4) eines Triebwerks eines Luftfahrzeugs zu betätigen, wobei der elektrische Leistungswandler (1) von einem Stromversorgungsnetz (2) des Luftfahrzeugs versorgt wird und ausgehend von einer Feldorientierungssteuerung gesteuert wird, die einen Stromeinstellwert nutzt, der ausgehend von einer direkten Stromkomponente und einer quadratischen Stromkomponente definiert wird, wobei das Verfahren die folgenden Schritte umfasst:
a) Empfangen (100) einer Steuerung zur Einleitung der integrierten Prüfung,
b) Steuern (120) des elektrischen Leistungswandlers (1) ausgehend von einem Stromeinstellwert, der ausgehend von einer direkten Komponente (I_{d_cons}) von ungleich Null und einer quadratischen Komponente (I_{q_cons}) von gleich Null definiert wird,
c) Messen (130) der in jeder der drei Phasen am Ausgang des elektrischen Leistungswandlers (1) gelieferten Ströme,
d) Bestimmen (140) der direkten und der quadratischen Komponente (I_{d}, I_{q}) des im vorhergehenden Schritt gemessenen Drehstroms,
e) Vergleichen (150) der direkten und der quadratischen Komponente (I_{d}, I_{q}) des gemessenen Stroms mit der direkten und der quadratischen Komponente (I_{d_cons}, I_{q_cons}) des Stromeinstellwerts, und
f) Senden (160) einer Benachrichtigung über die Fehlfunktion oder die Funktion der Schubumkehr in Abhängigkeit vom Ergebnis des Vergleichs an die Besatzung des Luftfahrzeugs.

2. Verfahren nach Anspruch 1, wobei eine Alarmbenachrichtigung im Schritt f) ausgegeben wird (160), wenn die gemessenen Komponenten (I_{d}, I_{q}) mit einer Varianz von den Komponenten (I_{d_cons}, I_{q_cons}) des Stromeinstellwerts abweichen, die höher als ein vorbestimmter Entscheidungsschwellenwert ist.

3. Verfahren nach einem der Ansprüche 1 oder 2, wobei keine Benachrichtigung (170) ausgegeben wird, wenn die gemessenen Komponenten (I_{d}, I_{q}) den Komponenten (I_{d_cons}, I_{q_cons}) des Stromeinstellwerts mit einer Varianz entsprechen, die niedriger als ein vorbestimmter Entscheidungsschwellenwert ist.

4. Verfahren nach einem der Ansprüche 1 oder 2, wobei eine Benachrichtigung über den Erfolg der Prüfung und der Funktionsfähigkeit der Schubumkehr ausgegeben wird, wenn die gemessenen Komponenten (I_{d}, I_{q}) den Komponenten d(I_{d_cons}, I_{q_cons}) des Stromeinstellwerts mit einer Varianz entsprechen, die niedriger als ein vorbestimmter Entscheidungsschwellenwert ist.

5. Verfahren nach einem der Ansprüche 1 bis 4, welches das Ausführen der Schritte b) bis f) für jedes Triebwerk des Luftfahrzeugs umfasst, wobei die Schritte b) bis f) gleichzeitig für alle Triebwerke oder aufeinanderfolgend für jedes Triebwerk ausgeführt werden.

6. System (10) zur Steuerung einer Phase der Prüfung eines elektrischen Leistungswandlers (1), wobei das Steuersystem (10) dazu bestimmt ist, in den geprüften elektrischen Leistungswandler (1) integriert zu werden, wobei der Wandler (1) dazu bestimmt ist, einen elektrischen Drehstrommotor (3) zu steuern, der dazu ausgestaltet ist, eine Schubumkehr (4) eines Triebwerks eines Luftfahrzeugs zu betätigen, wobei der elektrische Leistungswandler (1) dazu bestimmt ist, von einem Stromversorgungsnetz (2) des Luftfahrzeugs versorgt zu werden und ausgehend von einer Feldorientierungssteuerung gesteuert zu werden, die einen Stromeinstellwert nutzt, der ausgehend von einer direkten Stromkomponente und einer quadratischen Stromkomponente definiert wird,
**dadurch gekennzeichnet, dass** es Mittel (11) zum Empfangen eines Einstellwerts zur Einleitung der integrierten Prüfung, Mittel (8 und 9) zum Steuern des elektrischen Leistungswandlers (1) ausgehend von einem Stromeinstellwert, der ausgehend von einer direkten Komponente (I_{d_cons}) von ungleich Null und einer quadratischen Komponente (I_{q_cons}) von gleich Null definiert wird, Mittel (12) zum Messen der in jeder der drei Phasen am Ausgang des elektrischen Leistungswandlers (1) gelieferten Ströme, Mittel (13) zum Bestimmen der direkten und der quadratischen Komponente des im vorhergehenden Schritt gemessenen Drehstroms, Mittel (14) zum Vergleichen der direkten und der quadratischen Komponente des gemessenen Stroms mit der direkten und der quadratischen Komponente des Stromeinstellwerts und Mittel (15) zum Ausgeben einer Benachrichtigung über die Fehlfunktion oder die Funktion der Schubumkehr an die Besatzung des Luftfahrzeugs umfasst, die dazu ausgestaltet sind, eine Benachrichtigung in Abhängigkeit von dem Ergebnis des Vergleichs auszugeben.

7. Elektrischer Leistungswandler (1), der dazu bestimmt ist, von einem Stromversorgungsnetz (2) eines Luftfahrzeugs versorgt zu werden und an einen Drehstrommotor (3) gekoppelt zu sein, der dazu ausgestaltet ist, eine Schubumkehr (4) eines Triebwerks des Luftfahrzeugs zu betätigen, wobei der Wandler (1) dazu ausgestaltet ist, ausgehend von einer Feldorientierungssteuerung gesteuert zu werden, die einen Stromeinstellwert nutzt, der ausgehend von einer direkten Stromkomponente und einer quadratischen Stromkomponente definiert ist,
**dadurch gekennzeichnet, dass** der elektrische Leistungswandler (1) ein System (10) zur Steuerung einer Phase der Prüfung der Funktion des elektrischen Leistungswandlers (1) nach Anspruch 6 umfasst.

8. Triebwerk, das einen elektrischen Leistungswandler (1) nach dem vorhergehenden Anspruch umfasst, der elektrisch an einen elektrischen Permanentmagnet-Synchronmotor (3) gekoppelt ist, der dazu ausgestaltet ist, eine Schubumkehr (4) eines Triebwerks eines Luftfahrzeugs zu betätigen.

9. Luftfahrzeug, das mindestens ein Triebwerk nach dem vorhergehenden Anspruch umfasst.

## Claims

1. An integrated test method for testing the operation of an electrical power converter (1) controlling a three-phase electric motor (3) configured to actuate a thrust reverser (4) of an aircraft turbojet, the electrical power converter (1) being powered by an electrical power supply network (2) of the aircraft and being controlled by means of field-oriented control using a current setpoint defined from an in-phase current component and a quadratic current component, the method comprising the following steps:
a) receiving (100) an order to initiate the integrated test;
b) controlling (120) the electrical power converter (1) using a current setpoint defined from a non-zero in-phase component (I_{d_cons}) and a zero quadratic component (I_{q_cons});
c) measuring (130) the currents delivered on each of the three outlet phases of the electrical power converter (1);
d) determining (140) in-phase and quadratic components (I_{d}, I_{q}) of the three phase currents measured in the preceding step;
e) comparing (150) the in-phase and quadratic components (I_{d}, I_{q}) of the measured current with the in-phase and quadratic components (I_{d_cons}, I_{q_cons}) of the current setpoint; and
f) sending (160) a notification to the crew of the aircraft concerning the malfunctioning or the functioning of the thrust reverser as a function of the result of said comparison.

2. A method according to claim 1, wherein a warning notification is sent in step f) (160) if the measured components (I_{d}, I_{q}) differ from the current setpoint components (I_{d_cons}, I_{q_cons}) with variance greater than a predetermined decision threshold.

3. A method according to claim 1 or claim 2, wherein no notification (170) is sent if the measured components (I_{d}, I_{q}) correspond to the current setpoint components (I_{d_cons}, I_{q_cons}) with variance less than a predetermined decision threshold.

4. A method according to claim 1 or claim 2, wherein a notification that the test has been successful and that the thrust reverser is operating properly is sent if the measured components (I_{d}, I_{q}) correspond to the current setpoint components (I_{d_cons}, I_{q_cons}) with variance less than a predetermined decision threshold.

5. A method according to any one of claims 1 to 4, comprising performing the steps b) to f) for each turbojet of the aircraft, the steps b) to f) being performed simultaneously for all of the turbojets or successively for each turbojet.

6. A control system (10) for implementing a stage of testing an electrical power converter (1), the control system (10) being for integrating in the electrical power converter (1) for testing, said converter (1) being for controlling a three-phase electric motor (3) configured to actuate a thrust reverser (4) of a turbojet of an aircraft, the electrical power converter (1) being for powering by an electrical power supply network (2) of the aircraft and being controlled by means of field-oriented control using a current setpoint defined from an in-phase current component and a quadratic current component;
the system being **characterized in that** it comprises receiver means (11) for receiving an order to initiate the integrated test, control means (8 and 9) for controlling the electrical power converter (1) from a current setpoint defined from a nonzero in-phase component (I_{d_cons}) and a zero quadratic component (I_{q_cons}), measurement means (12) for measuring the current delivered on each of the three outlet phases of the electrical power converter (1), determination means (13) for determining the in-phase and quadratic components of the three phase currents measured in the preceding step, comparator means (14) for comparing the in-phase and quadratic components of the measured current with the in-phase and quadratic components of the current setpoint, and sender means (15) for sending a notification to the crew of the aircraft concerning malfunctioning or functioning of the thrust reverser and configured to send a notification as a function of the result of said comparison.

7. An electrical power converter (1) for being powered by an electrical power supply network (2) of an aircraft and for being coupled to a three-phase electric motor (3) configured to actuate a thrust reverser (4) of a turbojet of the aircraft, said converter (1) being configured to be controlled by means of field-oriented control using a current setpoint defined from an in-phase current component and a quadratic current component;
the electrical power converter (1) being **characterized in that** it includes a control system (10) for implementing a stage of testing the operation of said electrical power converter (1) according to claim 6.

8. A turbojet including an electrical power converter (1) according to the preceding claim, that is electrically coupled to a permanent magnet synchronous electric motor (3) configured to actuate a thrust reverser (4) of a turbojet of an aircraft.

9. An aircraft including at least one turbojet according to the preceding claim.
